# EUROPEAN PATENT APPLICATION

(11) **EP 4 386 847 A1**
(43) Date of publication of application: **19.06.2024**
(21) Application number: 22855716.1
(22) Date of filing: 25.03.2022
(51) Int. Cl.: H01L 27/146, H01L 29/417, H04N 25/76

(54) **IMAGING DEVICE AND ELECTRONIC APPARATUS**

(30) Priority: 13.08.2021 JP 2021131981
(71) Applicant: Sony Semiconductor Solutions Corporation, Atsugi-shi, Kanagawa 243-0014 (JP); Sony Group Corporation, Tokyo 108-0075 (JP)
(72) Inventor: OKABE, Hirokazu, Atsugi-shi, Kanagawa 243-0014 (JP); YAMASHITA, Hirofumi, Tokyo 108-0075 (JP)
(74) Representative: MFG Patentanwälte Meyer-Wildhagen Meggle-Freund Gerhard PartG mbB
(86) International application number: PCT/JP2022/014721
(87) International publication number: WO 2023/017650

(57) **Abstract**

A decrease in charge transfer efficiency is suppressed. An imaging apparatus according to an embodiment includes a plurality of pixels (2) arrayed in a two-dimensional lattice pattern, in which each of the pixels includes a photoelectric conversion unit (PD) that photoelectrically converts incident light, a gate electrode (108) that transfers charge accumulated in the photoelectric conversion unit, and a diffusion region (FD) to which the charge transferred from the photoelectric conversion unit flows, and the photoelectric conversion unit, the gate electrode, and the diffusion region are arrayed in a semiconductor substrate (11) along a substrate thickness direction of the semiconductor substrate.

## Description

### Field

The present disclosure relates to an imaging apparatus and an electronic device.

### Background

Conventionally, in a complementary metal-oxide-semiconductor (CMOS) type solid-state image pickup element (CMOS image sensor), in order to increase the amount of charges that can be accumulated in a photodiode that performs photoelectric conversion of a pixel portion, a potential that can accumulate charges in a deep region may be formed. In such a case, by using a vertical gate electrode inserted into silicon instead of a normal transfer gate, modulation is performed to a deep region, and an electric field is applied to perform reading. In addition, a structure employing a plurality of vertical gate electrodes in order to increase the modulation force has also been proposed.

### Citation List

### Patent Literature

Patent Literature 1: JP 2018-190797 A

### Summary

### Technical Problem

However, in the conventional element structure, it is difficult to make the path when the charge is extracted from the photoelectric conversion unit linear due to design restriction, and there is a problem that the charge transfer efficiency decreases.

Therefore, the present disclosure proposes an imaging apparatus and an electronic device capable of suppressing deterioration in charge transfer efficiency.

### Solution to Problem

To solve the problems described above, an imaging apparatus according to an embodiment of the present disclosure includes a plurality of pixels arrayed in a two-dimensional lattice pattern, wherein each of the pixels includes: a photoelectric conversion unit that photoelectrically converts incident light; a gate electrode that transfers charge accumulated in the photoelectric conversion unit; and a diffusion region to which the charge transferred from the photoelectric conversion unit flows, and the photoelectric conversion unit, the gate electrode, and the diffusion region are arrayed in a semiconductor substrate along a substrate thickness direction of the semiconductor substrate.

### Brief Description of Drawings

FIG. 1 is a block diagram depicting a schematic configuration example of an imaging apparatus applied to each embodiment of the present disclosure.
FIG. 2 is a diagram for explaining an example of a seat term structure of an imaging apparatus applied to each embodiment of the present disclosure.
FIG. 3 is a circuit diagram depicting an example of a pixel and a readout circuit depicted in FIG. 2.
FIG. 4 is a block diagram depicting a configuration example of an imaging apparatus mounted on an electronic device applied to each embodiment of the present disclosure.
FIG. 5 is a top view depicting a schematic configuration example of a pixel according to the first embodiment.
FIG. 6 is a vertical cross-sectional view depicting a structural example of an A-A' cross section in FIG. 5.
FIG. 7 is a vertical cross-sectional view depicting a structural example of a B-B' cross section in FIG. 5.
FIG. 8 is a horizontal cross-sectional view depicting a structural example of a C-C' cross section in FIG. 5.
FIG. 9 is a horizontal cross-sectional view depicting a structural example of a D-D' cross section in FIG. 5.
FIG. 10 is a process cross-sectional view depicting an example of a manufacturing process of the pixel according to the first embodiment (part 1).
FIG. 11 is a process cross-sectional view depicting an example of a manufacturing process of the pixel according to the first embodiment (part 2).
FIG. 12 is a process cross-sectional view depicting an example of a manufacturing process of the pixel according to the first embodiment (part 3).
FIG. 13 is a process cross-sectional view depicting an example of a manufacturing process of the pixel according to the first embodiment (part 4).
FIG. 14 is a process cross-sectional view depicting an example of a manufacturing process of the pixel according to the first embodiment (part 5).
FIG. 15 is a process cross-sectional view depicting an example of a manufacturing process of the pixel according to the first embodiment (part 6).
FIG. 16 is a process cross-sectional view depicting an example of a manufacturing process of the pixel according to the first embodiment (part 7).
FIG. 17 is a top view depicting a schematic configuration example of a pixel according to a second embodiment.
FIG. 18 is a vertical cross-sectional view depicting a structural example of an A-A' cross section in FIG. 17.
FIG. 19 is a vertical cross-sectional view depicting a structural example of a B-B' cross section in FIG. 17.
FIG. 20 is a top view depicting a schematic configuration example of a pixel according to a third embodiment.
FIG. 21 is a vertical cross-sectional view depicting a structural example of an A-A' cross section in FIG. 20.
FIG. 22 is a vertical cross-sectional view depicting a structural example of a B-B' cross section in FIG. 20.
FIG. 23 is a top view depicting a schematic configuration example of a pixel according to a fourth embodiment.
FIG. 24 is a vertical cross-sectional view depicting a structural example of an A-A' cross section in FIG. 23.
FIG. 25 is a vertical cross-sectional view depicting a structural example of a B-B' cross section in FIG. 23.
FIG. 26 is a top view depicting a schematic configuration example of a pixel according to a fifth embodiment.
FIG. 27 is a vertical cross-sectional view depicting a structural example of an A-A' cross section in FIG. 26.
FIG. 28 is a vertical cross-sectional view depicting a structural example of a B-B' cross section in FIG. 26.
FIG. 29 is a block diagram depicting an example of schematic configuration of a vehicle control system.
FIG. 30 is a diagram of assistance in explaining an example of installation positions of an outside-vehicle information detecting section and an imaging section.
FIG. 31 is a view depicting an example of a schematic configuration of an endoscopic surgery system.
FIG. 32 is a block diagram depicting an example of a functional configuration of a camera head and a camera control unit (CCU).

### Description of Embodiments

Hereinafter, an embodiment of the present disclosure will be described in detail with reference to the drawings. In the following embodiments, the same parts are denoted by the same reference numerals, and redundant description will be omitted.

Further, the present disclosure will be described according to the following order of items.
1. Common Configuration
   1.1 Schematic Configuration Example of Imaging Apparatus
   1.2 Stacked Structure Example of Imaging Apparatus
   1.3 Schematic Configuration Example of Electronic Device
2. First Embodiment
   2.1 Pixel Configuration Example
   2.2 Production Process Example
   2.3 Summary
3. Second Embodiment
4. Third Embodiment
5. Fourth Embodiment
6. Fifth Embodiment
7. Application Example to Mobile Body
8. Application Example to Endoscopic Surgery System

### 1. Common Configuration

First, configurations of an imaging apparatus and an electronic device common to the following embodiments will be described in detail with reference to the drawings.

### 1.1 Schematic Configuration Example of Imaging Apparatus

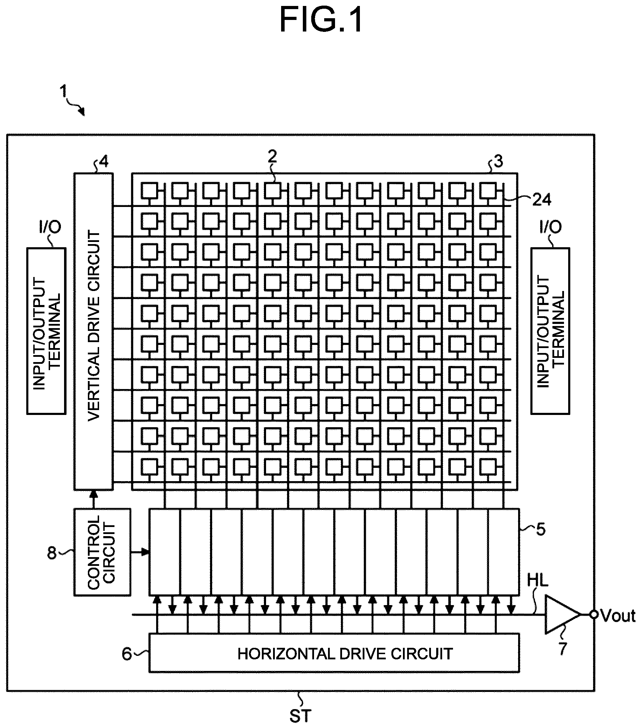

FIG. 1 is a block diagram depicting a schematic configuration example of an imaging apparatus applied to each embodiment of the present disclosure. As depicted in FIG. 1, the imaging apparatus 1 includes a pixel array unit (so-called imaging region) 3 in which pixels 2 including a plurality of photoelectric conversion elements are regularly and two-dimensionally arrayed on a semiconductor substrate ST (for example, a silicon substrate), and a peripheral circuit unit. The pixels 2 includes, for example, a photodiode serving as a photoelectric conversion element and a plurality of pixel transistors (so-called MOS transistors). The plurality of pixel transistors includes, for example, three transistors: a transfer transistor, a reset transistor, and an amplification transistor. In addition, a selection transistor may be added to configure the pixel transistor with four transistors. Since an equivalent circuit of the unit pixel is similar to a normal case, a detailed description thereof will be omitted. The pixels 2 may have a shared pixel structure. This pixel sharing structure includes a plurality of photodiodes, a plurality of transfer transistors, one shared floating diffusion, and each one of other shared pixel transistors.

The peripheral circuit unit includes a vertical drive circuit 4, column signal processing circuits 5, a horizontal drive circuit 6, an output circuit 7, and a control circuit 8, and the like.

The control circuit 8 receives an input clock and data instructing an operation mode and the like, and outputs data such as internal information of the imaging apparatus. That is, in the control circuit 8, a clock signal or a control signal serving as a reference of operations of the vertical drive circuit 4, the column signal processing circuit 5, the horizontal drive circuit 6, and the like is generated on the basis of the vertical synchronization signal, the horizontal synchronization signal, and the master clock. Then, these signals are input to the vertical drive circuit 4, the column signal processing circuits 5, the horizontal drive circuit 6, and the like.

The vertical drive circuit 4 includes, for example, a shift register, selects a pixel drive line, supplies a pulse for driving the pixels to the selected pixel drive line, and drives the pixels in units of rows. That is, the vertical drive circuit 4 sequentially selects and scans each of the pixels 2 in the pixel array unit 3 in the vertical direction in units of rows, and supplies a pixel signal based on a signal charge generated according to the amount of received light in, for example, a photodiode serving as a photoelectric conversion element of each of the pixels 2 to the column signal processing circuits 5 through the vertical signal line 24.

The column signal processing circuit 5 is arranged, for example, for each column of the pixels 2, and performs signal processing such as noise removal on the signals output from the pixels 2 of one row for each pixel column. That is, the column signal processing circuits 5 performs signal processing such as correlated double sampling (CDS) for removing fixed pattern noise unique to the pixels 2, signal amplification, and AD conversion. In the output stage of the column signal processing circuits 5, a horizontal selection switch (not illustrated) is connected and provided between the column signal processing circuit and a horizontal signal line HL.

The horizontal drive circuit 6 includes, for example, a shift register, sequentially selects each of the column signal processing circuits 5 by sequentially outputting horizontal scanning pulses, and causes each of the column signal processing circuits 5 to output a pixel signal to the horizontal signal line HL.

The output circuit 7 performs signal processing on the signals sequentially supplied from each of the column signal processing circuits 5 through the horizontal signal line HL, and outputs the processed signals. For example, only buffering may be performed, or black level adjustment, column variation correction, various digital signal processing, and the like may be performed. An input/output terminal I/O exchanges signals externally.

### 1.2 Stacked Structure Example of Imaging Apparatus

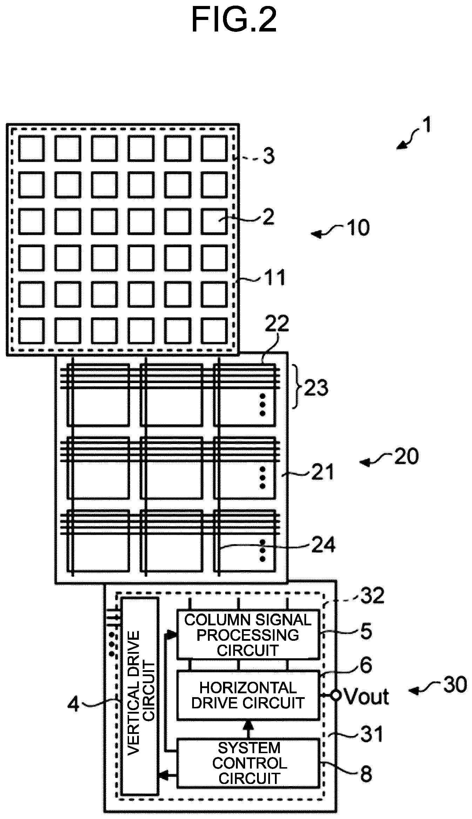

Next, a stacked structure example of the imaging apparatus 1 applied to each embodiment of the present disclosure will be described. FIG. 2 is a diagram for explaining an example of a seat term structure of an imaging apparatus applied to each embodiment of the present disclosure. As depicted in FIG. 2, the imaging apparatus 1 can have a three-dimensional structure formed by bonding three substrates (first substrate 10, second substrate 20, and third substrate 30). The first substrate 10, the second substrate 20, and the third substrate 30 are stacked in this order.

The first substrate 10 includes a plurality of pixels 2 that performs photoelectric conversion on the semiconductor substrate 11. The plurality of pixels 2 is provided in a matrix in the pixel array unit 3 of the first substrate 10. The second substrate 20 includes, on the semiconductor substrate 21, one readout circuit 22 for each of the four pixels 2 that outputs a pixel signal based on the charge output from the pixel 2. The second substrate 20 includes a plurality of pixel drive lines 23 extending in the row direction and a plurality of vertical signal lines 24 extending in the column direction. The third substrate 30 includes a logic circuit 32 that processes a pixel signal on the semiconductor substrate 31. The logic circuit 32 includes, for example, a vertical drive circuit 4, a column signal processing circuit 5, a horizontal drive circuit 6, and a control circuit 8. The logic circuit 32 (specifically, the horizontal drive circuit 6) outputs the output voltage Vout for each of the pixels 2 to the outside. In the logic circuit 32, for example, a low resistance region made of silicide formed using a self-aligned silicide process such as CoSi₂ or NiSi may be formed on the surface of the impurity diffusion region in contact with the source electrode and the drain electrode.

For example, the vertical drive circuit 4 sequentially selects the plurality of pixels 2 row by row. For example, the column signal processing circuit 5 performs CDS processing on the pixel signal output from each of the pixels 2 of the row selected by the vertical drive circuit 4. The column signal processing circuit 5 extracts a signal level of a pixel signal by performing CDS processing, for example, and holds pixel data corresponding to the amount of received light of each of the pixels 2. For example, the horizontal drive circuit 6 sequentially outputs the pixel data held in the column signal processing circuit 5 to the outside. The control circuit 8 controls driving of each block (vertical drive circuit 4, column signal processing circuit 5, and horizontal drive circuit 6) in the logic circuit 32, for example.

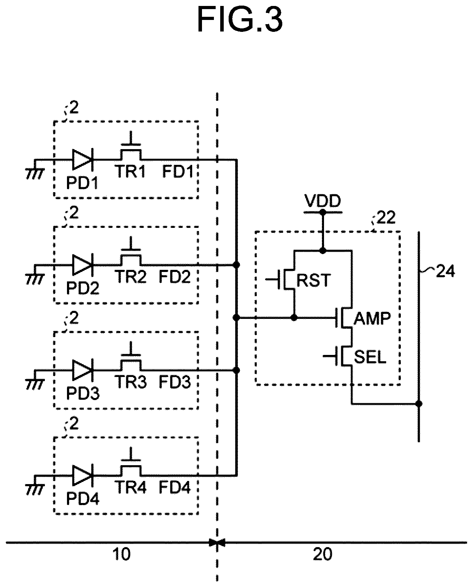

FIG. 3 illustrates an example of the pixels 2 and the readout circuit 22. Hereinafter, as illustrated in FIG. 3, a case where four pixels 2 share one readout circuit 22 will be described. Here, "share" means that the outputs of the four pixels 2 are input to the common readout circuit 22.

Each of the pixels 2 has a common component. In FIG. 3, identification numbers (1, 2, 3, and 4) are added to the ends of the signs of the constituent elements of each of the pixels 2 in order to distinguish the constituent elements of the pixels 2 from each other. Hereinafter, if it is necessary to distinguish the components of the pixels 2 from each other, an identification number is assigned to the end of the reference sign of the component of each of the pixels 2, but if it is not necessary to distinguish the components of the pixels 2 from each other, the identification number at the end of the reference sign of the component of each of the pixels 2 is omitted.

Each of the pixels 2 includes, for example, a photodiode PD, a transfer transistor TR electrically connected to the photodiode PD, and a floating diffusion region FD that temporarily holds the charge output from the photodiode PD via the transfer transistor TR. The photodiode PD corresponds to a specific example of a "photoelectric conversion unit" of the present disclosure. The photodiode PD performs photoelectric conversion to generate a charge corresponding to the amount of received light. A cathode of the photodiode PD is electrically connected to a source of the transfer transistor TR, and an anode of the photodiode PD is electrically connected to a reference potential line (for example, ground). The drain of the transfer transistor TR is electrically connected to the floating diffusion region FD, and the gate of the transfer transistor TR is electrically connected to the pixel drive line 23. The transfer transistor TR is, for example, a CMOS transistor.

The floating diffusion regions FD of the pixels 2 sharing one readout circuit 22 are electrically connected to each other and electrically connected to the input end of the common readout circuit 22. The readout circuit 22 includes, for example, a reset transistor RST, a selection transistor SEL, and an amplification transistor AMP. Note that the selection transistor SEL may be omitted as necessary. The source of the reset transistor RST (the input end of the readout circuit 22) is electrically connected to the floating diffusion region FD, and the drain of the reset transistor RST is electrically connected to the power supply line VDD and the drain of the amplification transistor AMP. A gate of the reset transistor RST is electrically connected to the pixel drive line 23 (see FIG. 2). The source of the amplification transistor AMP is electrically connected to the drain of the selection transistor SEL, and the gate of the amplification transistor AMP is electrically connected to the source of the reset transistor RST. A source of the selection transistor SEL (an output end of the readout circuit 22) is electrically connected to the vertical signal line 24, and a gate of the selection transistor SEL is electrically connected to the pixel drive line 23 (see FIG. 2).

### 1.3 Schematic Configuration Example of Electronic Device

In addition, the imaging apparatus 1 as described above can be applied to various electronic devices, such as an imaging system such as a digital still camera or a digital video camera, a mobile phone having an imaging function, or another device having an imaging function, for example.

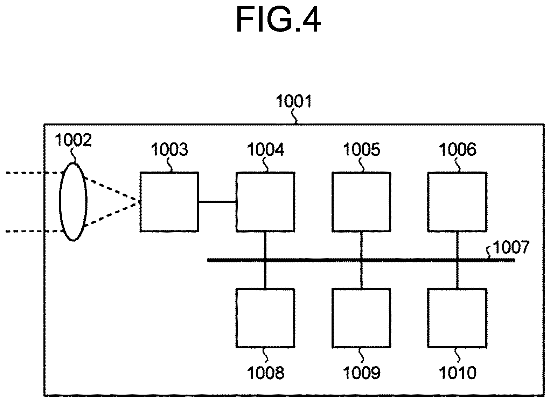

FIG. 4 is a block diagram depicting a configuration example of an imaging apparatus mounted on an electronic device.

As depicted in FIG. 4, an electronic device 1001 includes an optical system 1002, an imaging apparatus 1003, and a digital signal processor (DSP) 1004. The DSP 1004, a display apparatus 1005, an operation system 1006, a memory 1008, a recording apparatus 1009, and a power supply system 1010 are connected via a bus 1007, and can capture a still image and a moving image.

The optical system 1002 includes one or a plurality of lenses, guides image light from a subject (incident light) to the imaging apparatus 1003, and forms an image on a light receiving surface (sensor unit) of the imaging apparatus 1003.

As the imaging apparatus 1003, the imaging apparatus 1 of any of the above-described configuration examples is applied. Electrons are accumulated in the imaging apparatus 1003 for a certain period according to an image formed on the light receiving surface via the optical system 1002. Then, a signal corresponding to the electrons accumulated in the imaging apparatus 1003 is supplied to the DSP 1004.

The DSP 1004 performs various types of signal processing on the signal from the imaging apparatus 1003 to acquire an image, and temporarily stores data of the image in the memory 1008. The image data stored in the memory 1008 is recorded in the recording apparatus 1009 or supplied to the display apparatus 1005 to display an image. Furthermore, the operation system 1006 receives various operations by the user and supplies an operation signal to each block of the electronic device 1001, and the power supply system 1010 supplies power necessary for driving each block of the electronic device 1001.

In the electronic device 1001 configured as described above, by applying the imaging apparatus 1 as described above as the imaging apparatus 1003, the number of layers of a metal layer 58 can be more effectively reduced, and cost reduction can be achieved.

### 2. First Embodiment

First, an imaging apparatus and an electronic device according to the first embodiment will be described in detail with reference to the drawings. Note that, in the present embodiment, a pixel 100 may have a configuration corresponding to the pixels 2 provided on the first substrate 10 in the above-described common configuration example.

### 2.1 Pixel Configuration Example

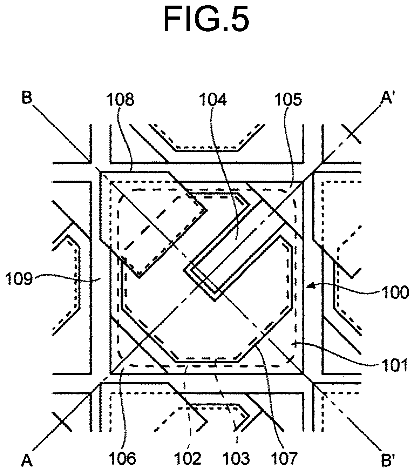

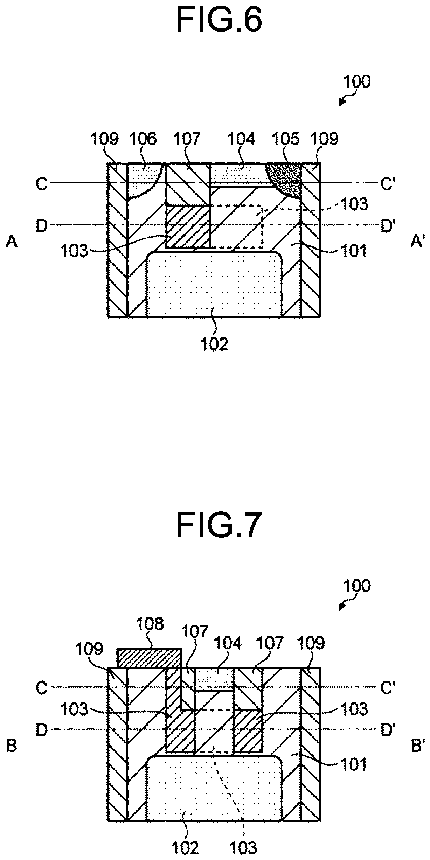

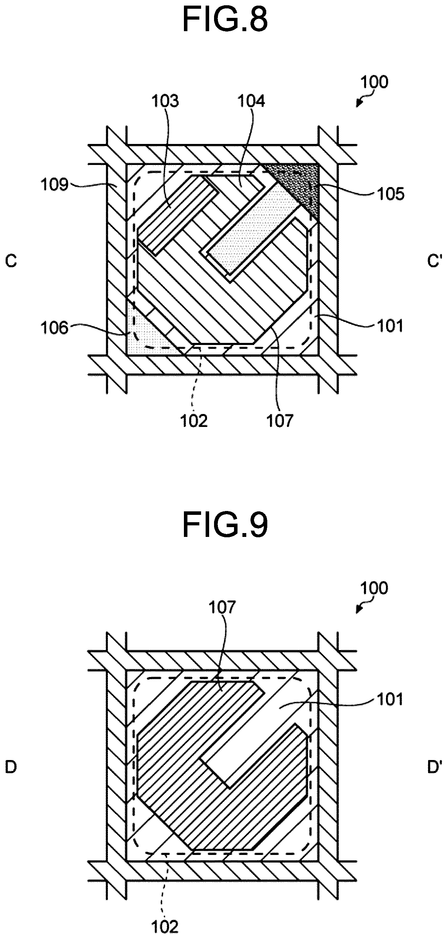

FIG. 5 is a top view depicting a schematic configuration example of a pixel according to the present embodiment. FIG. 6 is a vertical cross-sectional view depicting a structural example of an A-A' cross section in FIG. 5. FIG. 7 is a vertical cross-sectional view depicting a structural example of a B-B' cross section in FIG. 5. FIG. 8 is a horizontal cross-sectional view depicting a structural example of a C-C' cross section in FIG. 5. FIG. 9 is a horizontal cross-sectional view depicting a structural example of a D-D' cross section in FIG. 5.

As depicted in FIGS. 5 to 9, in the present embodiment, one pixel 100 is provided in each pixel region divided in a two-dimensional lattice pattern by a pixel isolation section 109 partitioning a semiconductor substrate 101.

The pixel 100 includes a photoelectric conversion unit 102 provided to be biased to, for example, the back surface side (lower surface side in the drawing) of the semiconductor substrate 101, an embedded gate electrode 103 arranged in proximity of the photoelectric conversion unit 102 in the substrate thickness direction, a transfer gate electrode 108 arranged on the upper surface of the semiconductor substrate 101 so as to contact with the embedded gate electrode 103, an embedded insulating film 107 provided on at least a part of the upper portion of the embedded gate electrode 103, a floating diffusion region 105 provided at one of the four corners of the pixel region in an upper layer of the semiconductor substrate 101, a diffusion region 104 provided on the upper layer of the semiconductor substrate 101 so as to connect from the substantially center of the pixel region to the floating diffusion region 105, and a ground contact 106 provided at a corner located diagonally to the corner where the floating diffusion region 105 is provided among the four corners of the pixel region in the upper layer of the semiconductor substrate 101.

In the above configuration, for example, the embedded gate electrode 103 is arranged so as to be close to a region below the diffusion region 104 (also referred to as a first region) protruding from the floating diffusion region 105 provided at one corner of the pixel region toward the center of the pixel region from at least one direction. In the present embodiment, the embedded gate electrode 103 has a U-shape (in particular, refer to FIGS. 5, 8, and 9.) so that the embedded gate electrode 103 is disposed so as to closely surround the region below the diffusion region 104 from three directions.

As described above, by arraying the photoelectric conversion unit 102, the embedded gate electrode 103, and the diffusion region 104 along the longitudinal direction (substrate thickness direction), when a voltage is applied to the embedded gate electrode 103 via the transfer gate electrode 108, a channel linearly connecting from the photoelectric conversion unit 102 located below the embedded gate electrode 103 to the diffusion region 104 located above is formed along the substrate thickness direction. As a result, the charge transfer efficiency from the photoelectric conversion unit 102 to the diffusion region 104 and the floating diffusion region 105 connected thereto can be enhanced.

In the above configuration, the embedded insulating film 107 is provided on the embedded gate electrode 103.

As described above, by replacing the upper portion of the embedded gate electrode 103 with an insulator such as the embedded insulating film 107, a distance from the floating diffusion region 105 to the embedded gate electrode 103 can be secured. As a result, it is possible to suppress the occurrence of an electron avalanche caused by the concentration of the electric field between the embedded gate electrode 103 and the floating diffusion region 105, thereby suppressing the occurrence of image quality deterioration such as a white spot caused by saturation of the amplitude of the pixel signal.

Similarly, by replacing the upper portion of the embedded gate electrode 103 with an insulator such as the embedded insulating film 107, it is also possible to secure a distance from the ground contact 106 to the embedded gate electrode 103, and thus, it is possible to suppress the occurrence of the electron avalanche and suppress the occurrence of image quality deterioration such as the white spot.

### 2.2 Production Process Example

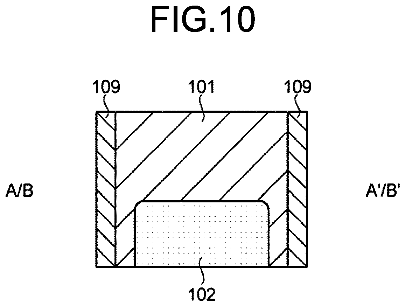

Next, an example of a manufacturing process of the pixel 100 according to the present embodiment will be described in detail with reference to the drawings. FIGS. 10 to 16 are process cross-sectional views depicting an example of a manufacturing process of the pixel according to the present embodiment. Note that FIG. 10 depicts a process cross-sectional view corresponding to both the A-A' cross section and the B-B' cross section in FIG. 5, FIGS. 11, 13, and 15 depict process cross-sectional views corresponding to the A-A' cross section in FIG. 5, and FIGS. 12, 14, and 16 depict process cross-sectional views corresponding to the B-B' cross section in FIG. 5.

In the present manufacturing process example, first, as depicted in FIG. 10, an N-type dopant is ion-implanted with predetermined implantation energy from the upper surface side into a semiconductor substrate 101 such as a silicon substrate, and the dopant thus implanted is thermally diffused to form the photoelectric conversion unit 102, which is a negative N-type diffusion region, in a region biased to the back surface side of the semiconductor substrate 101. For the semiconductor substrate 101, for example, a negative P-type semiconductor substrate may be used, or a P-type dopant may be thinly diffused. In the present description, the negative N-type refers to an N type having a small amount of free electrons, and the positive N type refers to an N type having a large amount of free electrons. Similarly, the negative P-type refers to a P type having a small amount of holes, and the positive P-type refers to a P type having a large amount of holes.

Subsequently, a trench reaching from the upper surface side to the back surface side is formed in a region where the pixel isolation section 109 for partitioning the semiconductor substrate 101 into individual pixel regions is formed, and the inside of the trench thus formed is filled with an insulator such as silicon oxide (SiO₂) or silicon nitride (SiN), thereby forming the pixel isolation section 109 that partitions the semiconductor substrate 101 into individual pixel regions.

Note that, in the present example, a so-called front full trench isolation (FFTI) type pixel isolation section reaching from the upper surface to the back surface of the semiconductor substrate 101 is exemplified as the pixel isolation section 109, but the pixel isolation section is not limited thereto, and a full trench isolation (FTI) type penetrating the semiconductor substrate 101 from the back surface side, or a deep trench isolation (DTI) type or reverse deep trench isolation (RDTI) type pixel isolation section formed from the front surface or the back surface to the middle of the semiconductor substrate 101 may be adopted.

Furthermore, in a case where the pixel isolation section 109 has a light confinement effect, a reflective material such as tungsten (W) may be embedded in a trench formed in the semiconductor substrate 101. At that time, when a conductive reflective material is embedded, an insulating layer may be provided between the semiconductor substrate 101 and the trench.

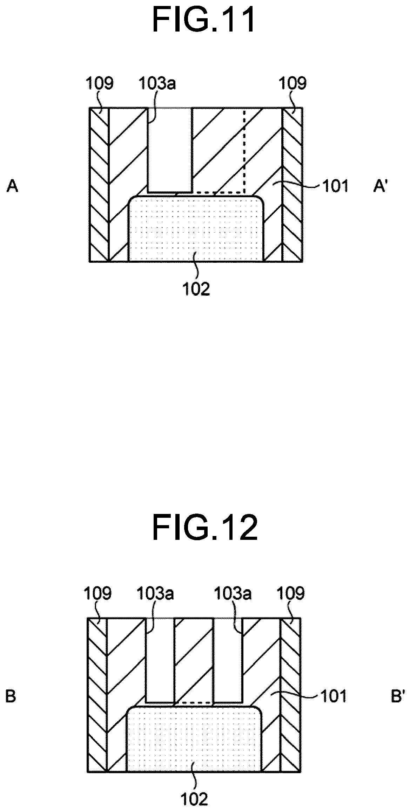

Next, as illustrated in FIGS. 11 and 12, the semiconductor substrate 101 is engraved from the front surface side to such an extent that the photoelectric conversion unit 102 is not reached, thereby forming a U-shaped trench 103a for forming the embedded gate electrode 103. For the formation of the trench 103a, for example, photolithography and dry etching can be used, and for the dry etching, for example, anisotropic dry etching such as reactive ion etching (RIE) can be used. However, the present invention is not limited thereto, and the trench 103a may be formed by various methods.

Next, a gate insulating film (not illustrated) is formed on the surface of the semiconductor substrate 101 inside the trench 103a. Annealing under an oxygen-rich condition can be used to form the gate insulating film. However, the present invention is not limited thereto, and the gate insulating film may be formed by using a sputtering method, a chemical vapor deposition (CVD) method, or the like. In addition, the insulating film formed on the upper surface of the semiconductor substrate 101 other than the inside of the trench 103a may be removed by chemical mechanical polishing (CMP), wet etching, or the like.

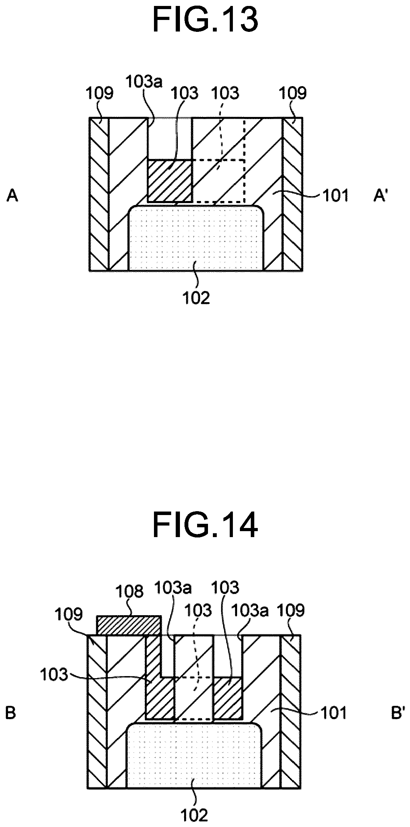

Next, as illustrated in FIGS. 13 and 14, the embedded gate electrode 103 is formed inside the trench 103a. The height of the embedded gate electrode 103 in the trench 103a may be such a height that the distance from the floating diffusion region 105 and/or the ground contact 106 formed in a later step is maintained at a distance such that the concentration of the electric field can be reduced. For example, the height of the embedded gate electrode 103 in the trench 103a may be about half the depth of the trench 103a.

In addition, for a material of the embedded gate electrode 103, polysilicon, amorphous silicon, or the like having conductivity by containing impurities may be used. However, the present invention is not limited thereto, and other conductive materials such as metals and alloys may be used.

For the formation of the embedded gate electrode 103, for example, a sputtering method, a CVD method, or the like may be used. Specifically, a conductive material may be deposited from the upper surface of the semiconductor substrate 101 so as to fill the inside of the trench 103a, the conductive material deposited on the upper surface of the semiconductor substrate 101 may be removed by CMP, wet etching, or the like, and then a trench for forming the embedded insulating film 107 may be formed in the trench 103a using, for example, photolithography and dry etching, whereby the embedded gate electrode 103 may be formed on the bottom side in the trench 103a. At that time, in order to bring the embedded gate electrode 103 at the bottom of the trench 103a into contact with the transfer gate electrode 108 on the semiconductor substrate 101, a part of the embedded gate electrode 103 in the trench 103a may be left up to the opening of the trench 103a (that is, the upper surface of the semiconductor substrate 101).

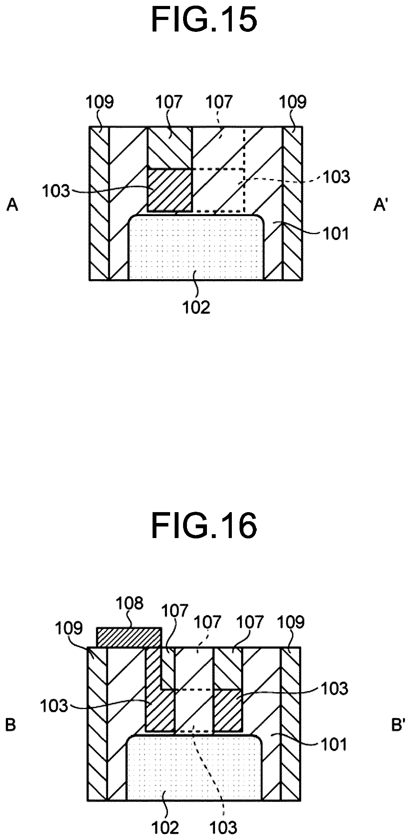

Next, as illustrated in FIGS. 15 and 16, the embedded insulating film 107 is formed in the trench 103a in which the embedded gate electrode 103 is formed. For the formation of the embedded insulating film 107, for example, a sputtering method, a CVD method, or the like may be used. Specifically, an insulating material may be deposited from the upper surface of the semiconductor substrate 101 so as to fill the remaining cavity in the trench 103a, and the insulating material deposited on the upper surface of the semiconductor substrate 101 may be removed by CMP, wet etching, or the like to form the embedded insulating film 107 on the upper side in the trench 103a. Note that silicon oxide (SiO₂), silicon nitride (SiN), or the like may be used as the insulating material of the embedded insulating film 107.

Subsequently, the transfer gate electrode 108 in contact with the embedded gate electrode 103 is formed on the semiconductor substrate 101. For a material of the transfer gate electrode 108, polysilicon, amorphous silicon, or the like having conductivity by containing impurities may be used. However, the present invention is not limited thereto, and other conductive materials such as metals and alloys may be used. Furthermore, in the formation of the transfer gate electrode 108, for example, a film forming process by a sputtering method, a CVD method, or the like, and a patterning process by photolithography and etching may be executed.

Next, the diffusion region 104 is formed in a region surrounded by the embedded insulating film 107 in the upper layer portion of the semiconductor substrate 101. In the formation of the diffusion region 104, a mask opened from a central portion of the pixel region to one of four corners (a corner where the floating diffusion region 105 is formed) is formed on the upper surface of the semiconductor substrate 101, and an N-type dopant is ion-implanted with predetermined implantation energy into the region opened by the mask, thereby forming the diffusion region 104 which is a negative N-type diffusion region.

Subsequently, the floating diffusion region 105 that is a positive N-type diffusion region is formed at one of four corners of the pixel region in the upper layer portion of the semiconductor substrate 101, and the ground contact 106 that is a positive P-type diffusion region is formed at a corner located diagonally to the corner, thereby forming the pixel structures illustrated in FIGS. 5 to 9. The floating diffusion region 105 and the ground contact 106 may be formed by the same process as the diffusion region 104 described above. However, the implanted dopant may be stabilized by performing annealing on the upper surface of the semiconductor substrate 101 after ion implantation into the floating diffusion region 105 and the ground contact 106.

### 2.3 Summary

As described above, according to the present embodiment, since the photoelectric conversion unit 102, the embedded gate electrode 103, and the diffusion region 104 are arrayed along the longitudinal direction (substrate thickness direction), the charge of the photoelectric conversion unit 102 can be linearly extracted to the diffusion region 104. As a result, it is possible to increase the transfer efficiency of the charge from the photoelectric conversion unit 102.

In addition, according to the present embodiment, since the embedded insulating film 107 is interposed between the embedded gate electrode 103 and the floating diffusion region 105/ground contact 106, it is possible to suppress occurrence of the electron avalanche caused by concentration of an electric field between the embedded gate electrode 103 and the floating diffusion region 105/ground contact 106. As a result, it is possible to suppress the occurrence of image quality degradation such as white spots caused by saturation of the amplitude of the pixel signal.

### 3. Second Embodiment

Next, an imaging apparatus and an electronic device according to the second embodiment will be described in detail with reference to the drawings. Note that, in the present embodiment, a pixel 200 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

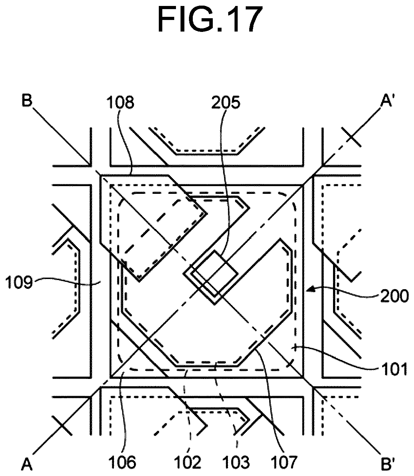

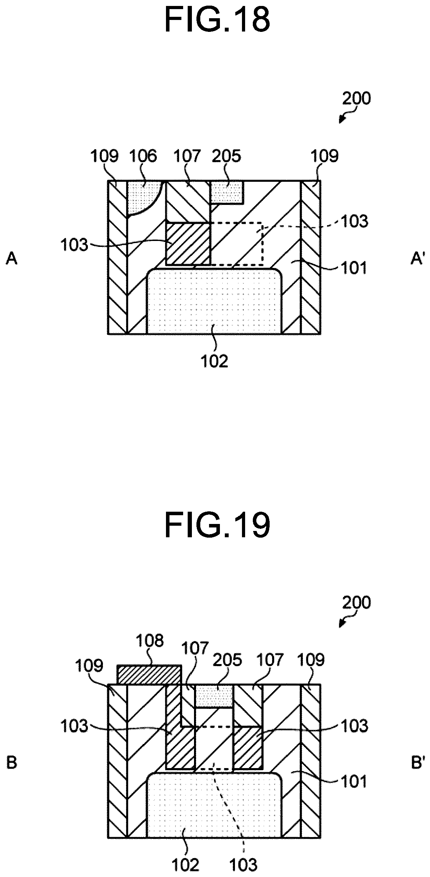

FIG. 17 is a top view depicting a schematic configuration example of a pixel according to the present embodiment. FIG. 18 is a vertical cross-sectional view depicting a structural example of an A-A' cross section in FIG. 17. FIG. 19 is a vertical cross-sectional view depicting a structural example of a B-B' cross section in FIG. 17.

As depicted in FIGS. 17 to 19, the pixel 200 according to the present embodiment has a structure in which the diffusion region 104 is omitted and the floating diffusion region 105 is replaced with a floating diffusion region 205 located substantially at the center of the pixel region in the same configuration as the pixel 100 described with reference to FIGS. 5 to 9 in the first embodiment.

As described above, even in a case of having the structure in which the floating diffusion region 105 is located substantially at the center of the pixel region, since the photoelectric conversion unit 102, the embedded gate electrode 103, and the floating diffusion region 205 are arrayed along the longitudinal direction (substrate thickness direction), the charge of the photoelectric conversion unit 102 can be linearly extracted to the floating diffusion region 205. As a result, it is possible to increase the transfer efficiency of the charge from the photoelectric conversion unit 102.

In addition, even in the structure according to the present embodiment, since the embedded insulating film 107 is interposed between the embedded gate electrode 103 and the floating diffusion region 205/ground contact 106, it is possible to suppress occurrence of the electron avalanche caused by concentration of an electric field between the embedded gate electrode 103 and the floating diffusion region 205/ground contact 106. As a result, it is possible to suppress the occurrence of image quality degradation such as white spots caused by saturation of the amplitude of the pixel signal.

Other configurations, operations, manufacturing processes, and effects may be similar to those of the above-described embodiment, and thus detailed description thereof is omitted here.

### 4. Third Embodiment

Next, an imaging apparatus and an electronic device according to the third embodiment will be described in detail with reference to the drawings. Note that, in the present embodiment, a pixel 300 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

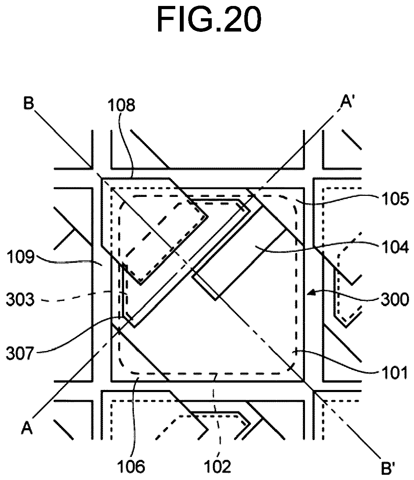

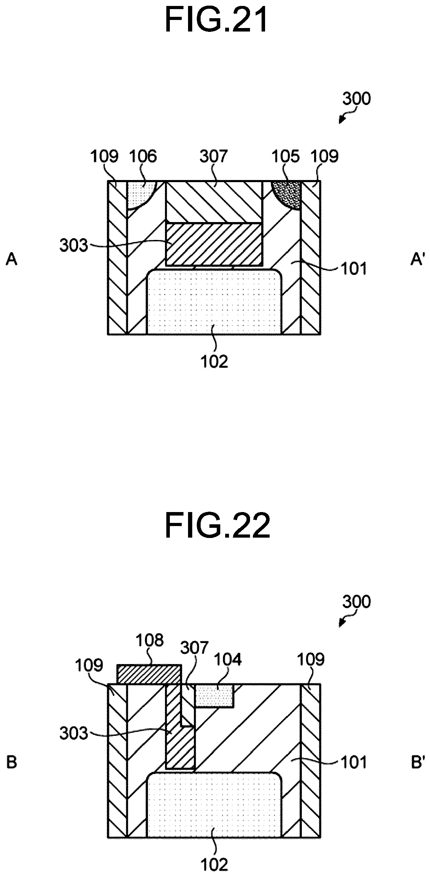

FIG. 20 is a top view depicting a schematic configuration example of a pixel according to the present embodiment. FIG. 21 is a vertical cross-sectional view depicting a structural example of an A-A' cross section in FIG. 20. FIG. 22 is a vertical cross-sectional view depicting a structural example of a B-B' cross section in FIG. 20.

As depicted in FIGS. 20 to 21, the pixel 300 according to the present embodiment has a structure in which the embedded gate electrode 103 and the embedded insulating film 107 are replaced with an embedded gate electrode 303 and an embedded insulating film 307 in the same configuration as the pixel 100 described with reference to FIGS. 5 to 9 in the first embodiment.

The embedded gate electrode 303 has a structure in which a portion located in the extending direction of the diffusion region 104 extending from the floating diffusion region 105 and a portion on the side where the transfer gate electrode 108 is not provided are omitted in the U-shaped structure of the embedded gate electrode 103 illustrated in FIGS. 5 to 9. In other words, the embedded gate electrode 303 has a structure in which the embedded gate electrode 303 is arranged only on one side of the region under the diffusion region 104 (the side on which the transfer gate electrode 108 is provided). Accordingly, in the present embodiment, the embedded insulating film 307 is disposed only on one side of the region under the diffusion region 104 (the side on which the transfer gate electrode 108 is provided).

In this way, by adopting a structure in which the embedded gate electrode 303 is arranged only on one side of the region under the diffusion region 104, the pixel region can be reduced. This makes it possible to achieve effects such as improvement in resolution and downsizing of the imaging apparatus 1.

Furthermore, even in a case of having the structure in which the embedded gate electrode 303 is disposed on one side of the region under the diffusion region 104, since the photoelectric conversion unit 102, the embedded gate electrode 303, and the diffusion region 104 are arrayed along the longitudinal direction (substrate thickness direction), the charge of the photoelectric conversion unit 102 can be linearly extracted to the diffusion region 104. As a result, it is possible to increase the transfer efficiency of the charge from the photoelectric conversion unit 102.

Furthermore, even in the structure according to the present embodiment, since the embedded insulating film 307 is interposed between the embedded gate electrode 303 and the floating diffusion region 105/ground contact 106, it is possible to suppress occurrence of the electron avalanche caused by concentration of an electric field between the embedded gate electrode 303 and the floating diffusion region 105/ground contact 106. As a result, it is possible to suppress the occurrence of image quality degradation such as white spots caused by saturation of the amplitude of the pixel signal.

In the present embodiment, the case based on the first embodiment has been exemplified, but the present invention is not limited thereto, and it can be based on other embodiments such as the second embodiment. Furthermore, other configurations, operations, manufacturing processes, and effects may be similar to those of the above-described embodiment, and thus detailed description thereof is omitted here.

### 5. Fourth Embodiment

Next, an imaging apparatus and an electronic device according to the fourth embodiment will be described in detail with reference to the drawings. Note that, in the present embodiment, a pixel 400 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

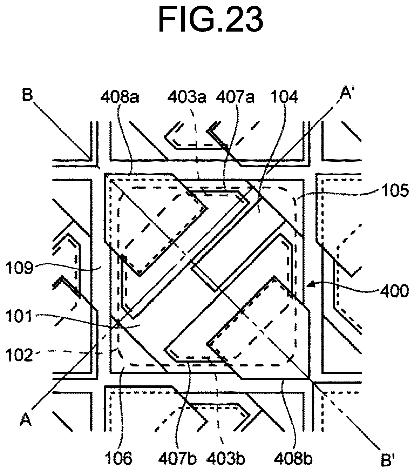

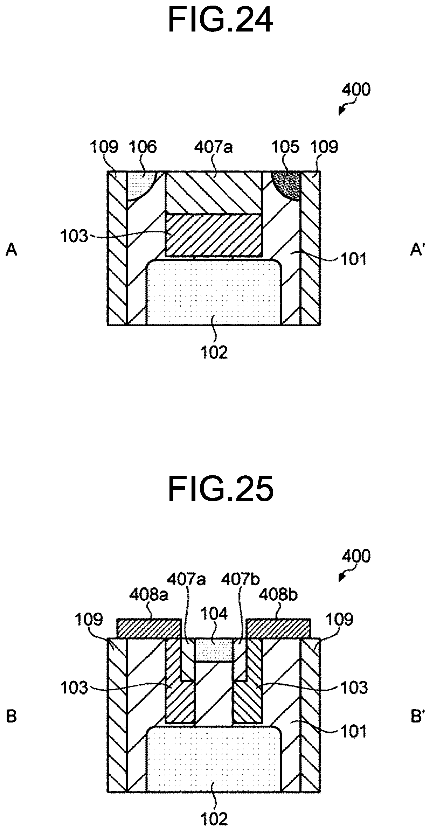

FIG. 23 is a top view depicting a schematic configuration example of a pixel according to the present embodiment. FIG. 24 is a vertical cross-sectional view depicting a structural example of an A-A' cross section in FIG. 23. FIG. 25 is a vertical cross-sectional view depicting a structural example of a B-B' cross section in FIG. 23.

As depicted in FIGS. 23 to 25, the pixel 400 according to the present embodiment has a structure in which the transfer gate electrode 108, the embedded gate electrode 103 and the embedded insulating film 107 are replaced with two transfer gate electrodes 408a and 408b, two separated embedded gate electrodes 403a and 403b, and two separated embedded insulating films 407a and 407b in the same configuration as the pixel 100 described with reference to FIGS. 5 to 9 in the first embodiment.

The embedded gate electrodes 403a and 403b have a structure in which a portion located in the extending direction of the diffusion region 104 extending from the floating diffusion region 105 is omitted in the U-shaped structure of the embedded gate electrode 103 illustrated in FIGS. 5 to 9. In other words, the embedded gate electrodes 403a and 403b have a structure in which the region under the diffusion region 104 is sandwiched from both sides. Accordingly, in the present embodiment, the embedded insulating films 407a and 407b are disposed to sandwich the region under the diffusion region 104 from both sides.

Among the two embedded gate electrodes 403a and 403b, the embedded gate electrode 403a is connected to the transfer gate electrode 408a, and the embedded gate electrode 403b is connected to the transfer gate electrode 408b positioned diagonally to the transfer gate electrode 408a.

As described above, even in a case of having the structure in which the embedded gate electrodes 403a and 403b sandwich the region under the diffusion region 104 from both sides, since the photoelectric conversion unit 102, the embedded gate electrodes 403a and 403b, and the diffusion region 104 are arrayed along the longitudinal direction (substrate thickness direction), the charge of the photoelectric conversion unit 102 can be linearly extracted to the diffusion region 104. As a result, it is possible to increase the transfer efficiency of the charge from the photoelectric conversion unit 102.

Furthermore, even in the structure according to the present embodiment, since the embedded insulating films 407a and 407b are interposed between the embedded gate electrodes 403a and 403b and the floating diffusion region 105/ground contact 106, it is possible to suppress occurrence of the electron avalanche caused by concentration of an electric field between the embedded gate electrodes 403a and 403b and the floating diffusion region 105/ground contact 106. As a result, it is possible to suppress the occurrence of image quality degradation such as white spots caused by saturation of the amplitude of the pixel signal.

In the present embodiment, the case based on the first embodiment has been exemplified, but the present invention is not limited thereto, and it can be based on other embodiments such as the second embodiment. Furthermore, other configurations, operations, manufacturing processes, and effects may be similar to those of the above-described embodiment, and thus detailed description thereof is omitted here.

### 6. Fifth Embodiment

Next, an imaging apparatus and an electronic device according to the fifth embodiment will be described in detail with reference to the drawings. Note that, in the present embodiment, a pixel 500 may have a configuration corresponding to the pixels 2 provided on the first substrate 10 in the above-described common configuration example. In addition, configurations, operations, manufacturing processes, and effects similar to those of the above-described embodiment are cited, and redundant descriptions thereof will be omitted.

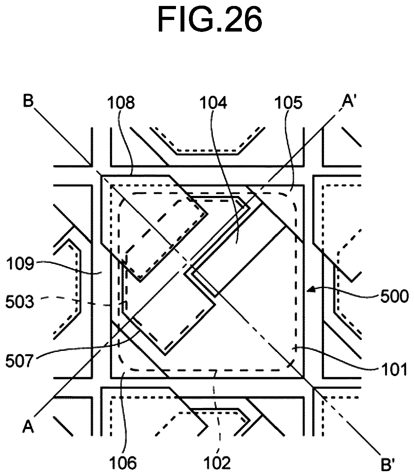

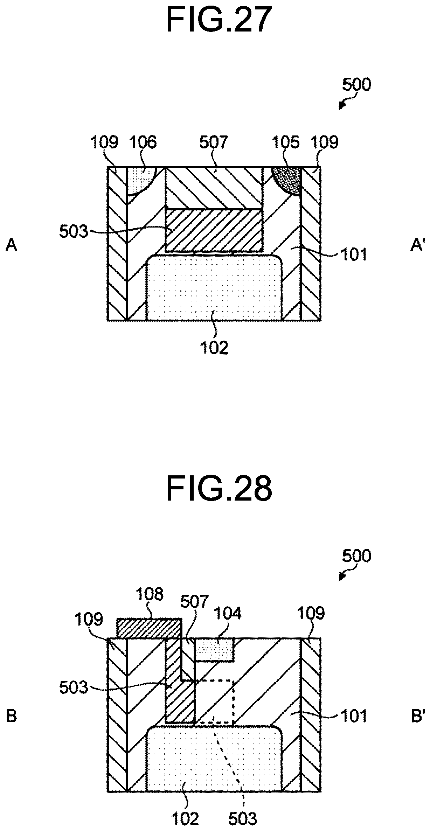

FIG. 26 is a top view depicting a schematic configuration example of a pixel according to the present embodiment. FIG. 27 is a vertical cross-sectional view depicting a structural example of an A-A' cross section in FIG. 26. FIG. 28 is a vertical cross-sectional view depicting a structural example of a B-B' cross section in FIG. 26.

As depicted in FIGS. 26 to 28, the pixel 500 according to the present embodiment has a structure in which the embedded gate electrode 103 and the embedded insulating film 107 are replaced with an L-shaped embedded gate electrode 503 and an L-shaped embedded insulating film 507 in the same configuration as the pixel 100 described with reference to FIGS. 5 to 9 in the first embodiment.

The embedded gate electrode 503 has a structure in which a portion on the side where the transfer gate electrode 108 is not provided are omitted in the U-shaped structure of the embedded gate electrode 103 illustrated in FIGS. 5 to 9. In other words, the embedded gate electrode 503 has a structure in which the region under the diffusion region 104 is surrounded from the side on which the transfer gate electrode 108 is provided and the side on which the ground contact 106 is provided. Accordingly, in the present embodiment, the embedded insulating film 507 is disposed only so as to surround the region under the diffusion region 104 from the side on which the transfer gate electrode 108 is provided and the side on which the ground contact 106 is provided.

As described above, even in a case of having the structure in which the embedded gate electrode 503 sandwiches the region under the diffusion region 104 from the side on which the transfer gate electrode 108 is provided and the side on which the ground contact 106 is provided, since the photoelectric conversion unit 102, the embedded gate electrode 503, and the diffusion region 104 are arranged along the longitudinal direction (substrate thickness direction), the charge of the photoelectric conversion unit 102 can be linearly extracted to the diffusion region 104. As a result, it is possible to increase the transfer efficiency of the charge from the photoelectric conversion unit 102.

Furthermore, even in the structure according to the present embodiment, since the embedded insulating film 507 is interposed between the embedded gate electrode 503 and the floating diffusion region 105/ground contact 106, it is possible to suppress occurrence of the electron avalanche caused by concentration of an electric field between the embedded gate electrode 503 and the floating diffusion region 105/ground contact 106. As a result, it is possible to suppress the occurrence of image quality degradation such as white spots caused by saturation of the amplitude of the pixel signal.

In the present embodiment, the case based on the first embodiment has been exemplified, but the present invention is not limited thereto, and it can be based on other embodiments such as the second embodiment. Furthermore, other configurations, operations, manufacturing processes, and effects may be similar to those of the above-described embodiment, and thus detailed description thereof is omitted here.

### 7. Application Example to Mobile Body

The technology according to the present disclosure (present technology) can be applied to various products. For example, the technology according to the present disclosure may be realized as devices mounted on any types of mobile bodies such as automobiles, electric vehicles, hybrid electric vehicles, motorcycles, bicycles, personal mobilities, airplanes, drones, ships, and robots.

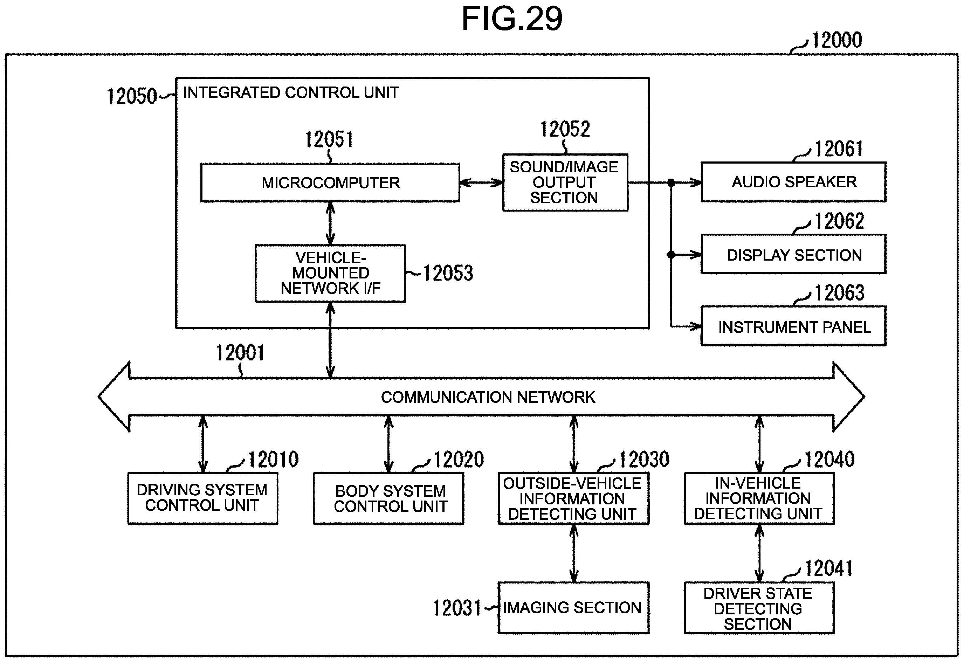

FIG. 29 is a block diagram depicting an example of schematic configuration of a vehicle control system as an example of a mobile body control system to which the technology according to an embodiment of the present disclosure can be applied.

A vehicle control system 12000 includes a plurality of electronic control units connected to each other via a communication network 12001. In the example depicted in FIG. 29, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 29, an audio speaker 12061, a display section 12062, and an instrument panel 12063 are illustrated as the output device. The display section 12062 may, for example, include at least one of an on-board display and a head-up display.

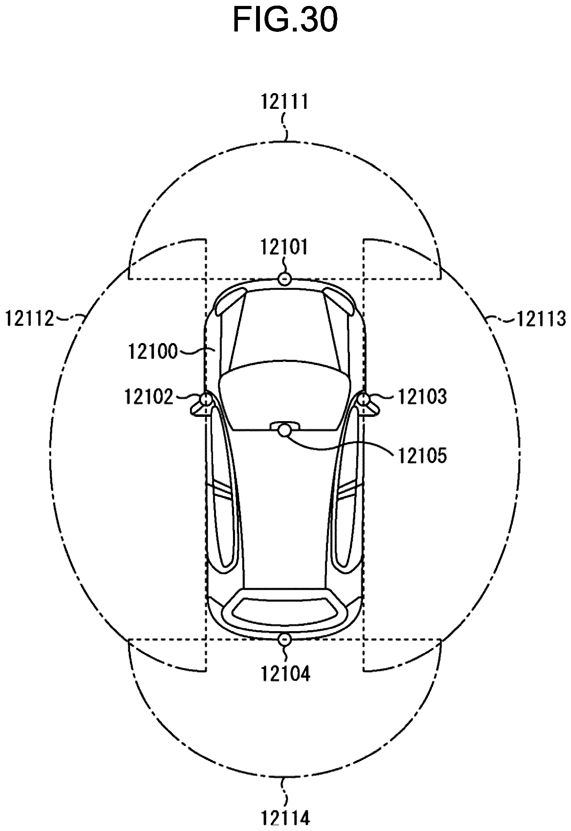

FIG. 30 is a diagram depicting an example of the installation position of the imaging section 12031.

In FIG. 30, a vehicle 12100 includes imaging sections 12101, 12102, 12103, 12104, and 12105 as the imaging section 12031.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The image of the front of the vehicle obtained by the imaging sections 12101 and 12105 is used mainly to detect a preceding vehicle, a pedestrian, an obstacle, a signal, a traffic sign, a lane, or the like.

Incidentally, FIG. 30 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example of the vehicle control system to which the technology related to the present disclosure can be applied is described. The technology according to the present disclosure can be applied to the imaging section 12031 within the above-described configuration. By applying the technology according to the present disclosure to the imaging section 12031, it is possible to acquire an image with good image quality, thereby achieving various effects such as improving the accuracy of various detection processes.

### 8. Application Example to Endoscopic Surgery System

The technology according to the present disclosure (present technology) can be applied to various products. For example, the technology according to the present disclosure may be applied to an endoscopic surgery system.

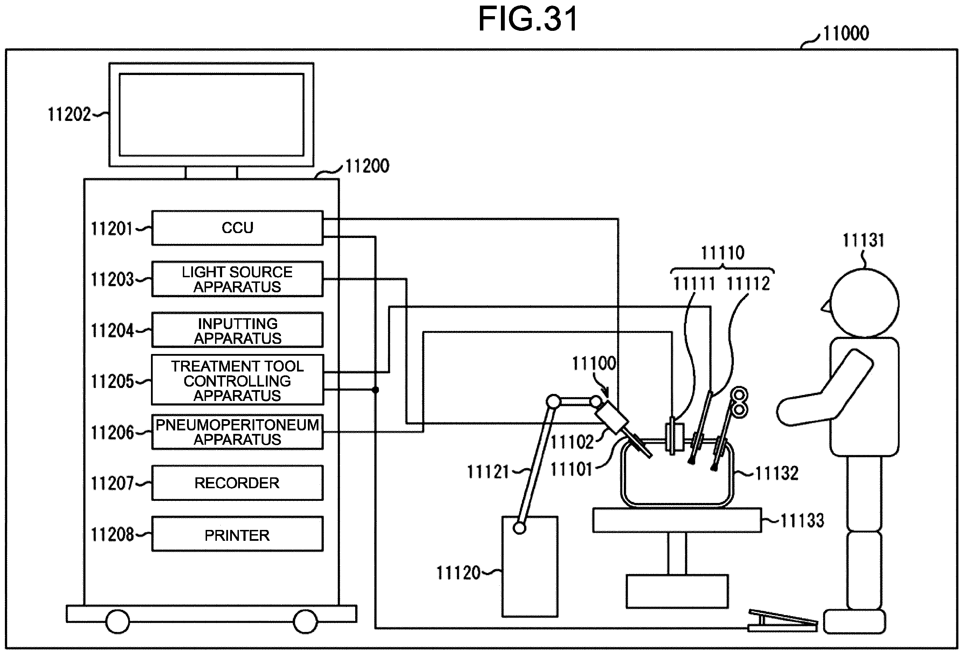

FIG. 31 is a view depicting an example of a schematic configuration of an endoscopic surgery system to which the technology according to an embodiment of the present disclosure (present technology) can be applied.

In FIG. 31, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy treatment tool 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body lumen of the patient 11132, and a camera head 11102 connected to a proximal end of the lens barrel 11101. In the example depicted, the endoscope 11100 is depicted which includes as a hard mirror having the lens barrel 11101 of the hard type. However, the endoscope 11100 may otherwise be included as a soft mirror having the lens barrel 11101 of the soft type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body lumen of the patient 11132 through the objective lens. It is to be noted that the endoscope 11100 may be a direct view mirror or may be a perspective view mirror or a side view mirror.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy treatment tool 11112 for cautery or incision of a tissue, sealing of a blood vessel or the like. A pneumoperitoneum apparatus 11206 feeds gas into a body lumen of the patient 11132 through the pneumoperitoneum tube 11111 to inflate the body lumen in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrowband light and/or excitation light suitable for special light observation as described above.

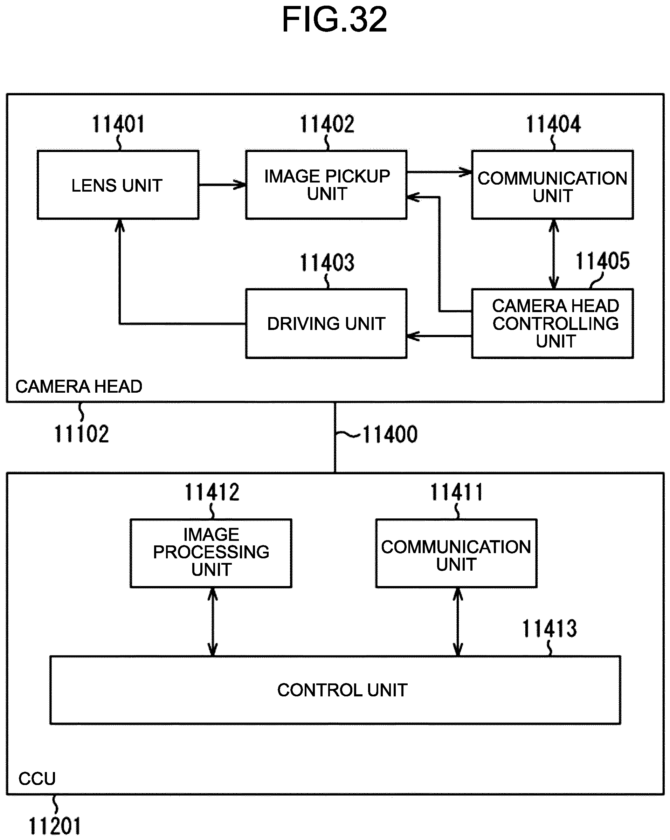

FIG. 32 is a block diagram depicting an example of a functional configuration of the camera head 11102 and the CCU 11201 depicted in FIG. 31.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes an image pickup element. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy treatment tool 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

In the above, an example of the endoscopic surgery system to which the technology related to the present disclosure can be applied is described. The technology according to the present disclosure can be applied to, for example, the endoscope 11100, (the image pickup unit 11402 of) the camera head 11102, (the image processing unit 11412) of the CCU 11201 or the like within the above-described configuration. By applying the technology according to the present disclosure to these configurations, a clearer image of the operation site can be obtained, so that the operator can reliably confirm the operation site.

Note that, here, the endoscopic surgery system has been described as an example, but the technology according to the present disclosure may be applied to, for example, a microscopic surgery system or the like.

Although the embodiments of the present disclosure have been described above, the technical scope of the present disclosure is not limited to the embodiments described above as it is, and various modifications can be made without departing from the gist of the present disclosure. In addition, constituent elements of different embodiments and modifications may be appropriately combined.

Furthermore, the effects of the embodiments described in the present specification are merely examples and are not limited, and other effects may be provided.

Note that the present technology can also have the following configurations.
(1) An imaging apparatus including
   a plurality of pixels arrayed in a two-dimensional lattice pattern, wherein
   each of the pixels includes:
      a photoelectric conversion unit that photoelectrically converts incident light;
      a gate electrode that transfers charge accumulated in the photoelectric conversion unit; and
      a diffusion region to which the charge transferred from the photoelectric conversion unit flows, and
      the photoelectric conversion unit, the gate electrode, and the diffusion region are arrayed in a semiconductor substrate along a substrate thickness direction of the semiconductor substrate.
(2) The imaging apparatus according to (1), further including
   a pixel isolation section that partitions at least an upper surface of the semiconductor substrate into a plurality of pixel regions arrayed in a two-dimensional lattice pattern, wherein
   each of the pixels is provided on a one-to-one basis in each of the pixel regions,
   the diffusion region is disposed at a substantially center of the pixel region on the upper surface of the semiconductor substrate,
   the gate electrode is disposed close to a first region under the diffusion region in the substrate thickness direction, and
   the photoelectric conversion unit is disposed in a second region below the diffusion region in the substrate thickness direction and close to a back surface side of the semiconductor substrate.
(3) The imaging apparatus according to (2), wherein
   the gate electrode comes close to the first region from at least one direction.
(4) The imaging apparatus according to (2), wherein
   the gate electrode has an L-shape when viewed from the upper surface side, and comes close to the first region from two directions.
(5) The imaging apparatus according to (2), wherein
   the gate electrode includes:
   a first gate electrode that comes close to the first region from a first direction; and
   a second gate electrode that comes close from a second direction opposite to the first direction across the first region.
(6) The imaging apparatus according to (2), wherein
   the gate electrode has a U-shape when viewed from the upper surface side, and comes close to the first region from three directions.
(7) The imaging apparatus according to any one of (2) to (6), further including
   a floating diffusion region that is provided at one of four corners of the pixel region and accumulates the charge transferred from the photoelectric conversion unit, wherein
   the diffusion region extends from the substantially center of the pixel region to the floating diffusion region.
(8) The imaging apparatus according to any one of (2) to (6), wherein
   the diffusion region is a floating diffusion region that accumulates the charge transferred from the photoelectric conversion unit.
(9) The imaging apparatus according to any one of (1) to (8), wherein
   each of the pixels further includes an embedded insulating film disposed between the gate electrode and the diffusion region.
(10) The imaging apparatus according to any one of (1) to (8), further including
   a pixel isolation section that partitions at least an upper surface of the semiconductor substrate into a plurality of pixel regions arrayed in a two-dimensional lattice pattern, wherein
   each of the pixels is provided on a one-to-one basis in each of the pixel regions, and
   each of the pixels further includes:
      a floating diffusion region that is provided at one of four corners of the pixel region and accumulates the charge transferred from the photoelectric conversion unit; and
      an embedded insulating film disposed between the gate electrode and the floating diffusion region.
(11) The imaging apparatus according to (10), wherein
   each of the pixels further includes a ground contact provided at one of four corners of the pixel region and grounding the semiconductor substrate, and
   the embedded insulating film is further disposed between the gate electrode and the ground contact.
(12) The imaging apparatus according to any one of (9) to (11), wherein
   the embedded insulating film is disposed from an upper surface of the semiconductor substrate to an upper surface of the gate electrode.
(13) An electronic device including the imaging apparatus according to any one of (1) to (12).

### Reference Signs List

1, 1003 IMAGING APPARATUS
2, 100, 200, 300, 400, 500 PIXEL
3 PIXEL ARRAY UNIT
4 VERTICAL DRIVE CIRCUIT
5 COLUMN SIGNAL PROCESSING CIRCUIT
6 HORIZONTAL DRIVE CIRCUIT
7 OUTPUT CIRCUIT
8 CONTROL CIRCUIT
10 FIRST SUBSTRATE
11, 21, 31, 101 SEMICONDUCTOR SUBSTRATE
20 SECOND SUBSTRATE
22 READOUT CIRCUIT
23 PIXEL DRIVE LINE
24 VERTICAL SIGNAL LINE
30 THIRD SUBSTRATE
32 LOGIC CIRCUIT
102 PHOTOELECTRIC CONVERSION UNIT
103, 303, 403a, 403b, 503 EMBEDDED GATE ELECTRODE
104 DIFFUSION REGION
105, 205, FD FLOATING DIFFUSION REGION
106 GROUND CONTACT
107, 307, 407a, 407b, 507 EMBEDDED INSULATING FILM
108, 408a, 408b TRANSFER GATE ELECTRODE
109 PIXEL ISOLATION SECTION
1001 ELECTRONIC DEVICE
1002 OPTICAL SYSTEM
1004 DSP
1005 DISPLAY APPARATUS
1006 OPERATION SYSTEM
1007 BUS
1008 MEMORY
1009 RECORDING APPARATUS
1010 POWER SUPPLY SYSTEM
AMP AMPLIFICATION TRANSISTOR
PD PHOTODIODE
RST RESET TRANSISTOR
SEL SELECTION TRANSISTOR
TR TRANSFER TRANSISTOR

## Claims

1. An imaging apparatus including
a plurality of pixels arrayed in a two-dimensional lattice pattern, wherein
each of the pixels includes:
a photoelectric conversion unit that photoelectrically converts incident light;
a gate electrode that transfers charge accumulated in the photoelectric conversion unit; and
a diffusion region to which the charge transferred from the photoelectric conversion unit flows, and
the photoelectric conversion unit, the gate electrode, and the diffusion region are arrayed in a semiconductor substrate along a substrate thickness direction of the semiconductor substrate.

2. The imaging apparatus according to claim 1, further including
a pixel isolation section that partitions at least an upper surface of the semiconductor substrate into a plurality of pixel regions arrayed in a two-dimensional lattice pattern, wherein
each of the pixels is provided on a one-to-one basis in each of the pixel regions,
the diffusion region is disposed at a substantially center of the pixel region on the upper surface of the semiconductor substrate,
the gate electrode is disposed close to a first region under the diffusion region in the substrate thickness direction, and
the photoelectric conversion unit is disposed in a second region below the diffusion region in the substrate thickness direction and close to a back surface side of the semiconductor substrate.

3. The imaging apparatus according to claim 2, wherein
the gate electrode comes close to the first region from at least one direction.

4. The imaging apparatus according to claim 2, wherein
the gate electrode has an L-shape when viewed from the upper surface side, and comes close to the first region from two directions.

5. The imaging apparatus according to claim 2, wherein
the gate electrode includes:
a first gate electrode that comes close to the first region from a first direction; and
a second gate electrode that comes close from a second direction opposite to the first direction across the first region.

6. The imaging apparatus according to claim 2, wherein
the gate electrode has a U-shape when viewed from the upper surface side, and comes close to the first region from three directions.

7. The imaging apparatus according to claim 2, further including
a floating diffusion region that is provided at one of four corners of the pixel region and accumulates the charge transferred from the photoelectric conversion unit, wherein
the diffusion region extends from the substantially center of the pixel region to the floating diffusion region.

8. The imaging apparatus according to claim 2, wherein
the diffusion region is a floating diffusion region that accumulates the charge transferred from the photoelectric conversion unit.

9. The imaging apparatus according to claim 1, wherein
each of the pixels further includes an embedded insulating film disposed between the gate electrode and the diffusion region.

10. The imaging apparatus according to claim 1, further including
a pixel isolation section that partitions at least an upper surface of the semiconductor substrate into a plurality of pixel regions arrayed in a two-dimensional lattice pattern, wherein
each of the pixels is provided on a one-to-one basis in each of the pixel regions, and
each of the pixels further includes:
a floating diffusion region that is provided at one of four corners of the pixel region and accumulates the charge transferred from the photoelectric conversion unit; and
an embedded insulating film disposed between the gate electrode and the floating diffusion region.

11. The imaging apparatus according to claim 10, wherein
each of the pixels further includes a ground contact provided at one of four corners of the pixel region and grounding the semiconductor substrate, and
the embedded insulating film is further disposed between the gate electrode and the ground contact.

12. The imaging apparatus according to claim 9, wherein
the embedded insulating film is disposed from an upper surface of the semiconductor substrate to an upper surface of the gate electrode.

13. An electronic device including the imaging apparatus according to claim 1.
